# EUROPÄISCHE PATENTSCHRIFT

(11) **EP 3 831 717 B1**
(45) Veröffentlichungstag und Bekanntmachung des Hinweises auf die Patenterteilung: **19.02.2025**
(21) Anmeldenummer: 19212887.4
(22) Anmeldetag: 02.12.2019
(51) Int. Cl.: B64D 11/00, G06F 30/15, B64F 5/00

(54) **VERFAHREN ZUM AUTOMATISIERTEN AUSWÄHLEN UND ANORDNEN EINER MEHRZAHL VON STRUKTURELLEN ELEMENTEN IN EINEM BEGRENZTEN RAUM**
METHOD FOR AUTOMATICALLY SELECTING AND ARRANGING A PLURALITY OF STRUCTURAL ELEMENTS IN A LIMITED SPACE
PROCÉDÉ DE SÉLECTION ET D'AGENCEMENT AUTOMATISÉS D'UNE PLURALITÉ D'ÉLÉMENTS STRUCTURELS DANS UNE PIÈCE LIMITÉE

(43) Veröffentlichungstag der Anmeldung: 09.06.2021
(73) Patentinhaber: Airbus Operations GmbH, 21129 Hamburg (DE); Airbus (S.A.S.), 31700 Blagnac (FR)
(72) Erfinder: Gonnsen, Johannes, 21129 Hamburg (DE); Smith, Garrett, 31700 Blagnac (FR); Zenker, Marcel, 21129 Hamburg (DE)
(74) Vertreter: Bird & Bird LLP - Hamburg

(56) Entgegenhaltungen:
- EP-A1- 2 960 839
- EP-A1- 3 101 615
- DE-A1- 102015 117 181
- US-B2- 8 060 345

## Beschreibung

Die vorliegende Erfindung betrifft ein Verfahren zum automatisierten Auswählen einer Mehrzahl von strukturellen Elementen für einen begrenzten Raum und automatisierten Anordnen der Mehrzahl von strukturellen Elementen in dem begrenzten Raum, ein Verfahren zur Evaluierung eines Prozesses für eine Mehrzahl von verschiedenen Konfigurationen eines begrenzten Raumes, ein Verfahren zur Herstellung einer Fahrzeugkabine sowie ein System zum automatisierten Auswählen einer Mehrzahl von strukturellen Elementen für einen begrenzten Raum und automatisierten Anordnen der Mehrzahl von strukturellen Elementen in dem begrenzten Raum.

Zur Reduzierung des Aufwandes, der mit der Konfiguration eines begrenzten Raumes, wie einer Flugzeugkabine, unter Berücksichtigung einer Vielzahl von Anforderungen und technischen Regeln verbunden ist, können computergestützte Systeme verwendet werden, mit denen Elemente in der Flugzeugkabine von einem Nutzer angeordnet werden können. Das System überprüft fortlaufend, ob die von dem Nutzer vorgesehene Anordnung angesichts der beispielsweise in einer Datenbank hinterlegten technischen Regeln zulässig ist. Dem Nutzer wird somit bereits frühzeitig mitgeteilt, ob eine vorgesehene Konfiguration einer Flugzeugkabine überhaupt technisch realisierbar ist. Dadurch wird im Vergleich zu einem System, bei dem die Überprüfung der Einhaltung der technischen Regeln erst nach Abschluss der Planung erfolgt, erheblicher Aufwand vermieden.

Ebenfalls bekannt sind Systeme und Verfahren, bei denen die Konfiguration einer Flugzeugkabine automatisch auf Grundlage von kundenspezifischen Konfigurationsdaten und technischen Regeln erzeugt wird. So sind beispielsweise aus EP 2 960 839 A1 ein System und ein Verfahren zur automatischen Erzeugung von Kabinenlayouts für Flugzeugkabinen bekannt. Dabei gibt ein Nutzer über ein Eingabemodul kundenspezifische Konfigurationsdaten für eine Flugzeugkabine vor, die unter anderem bestimmte Einrichtungskomponenten für die Kabine identifizieren und Positionen der Einrichtungskomponenten angeben. Zudem ist eine Datenbank mit Regeln vorgesehen, die die Installation von Einrichtungskomponenten in der Flugzeugkabine betreffen. Mittels einer Verarbeitungseinheit wird aus den kundenspezifischen Konfigurationsdaten unter Berücksichtigung der in der Datenbank hinterlegten Regeln ein Kabinenlayout für eine Flugzeugkabine ermittelt.

Weiterhin ist aus EP 3 101 615 A1 ein System bekannt, mit dem ein Flugzeug konfiguriert werden kann. Das System umfasst ein Eingabemodul, mit dem kundenspezifische Design- oder Konfigurationsdaten für ein Flugzeug eingegeben werden können, sowie eine Datenbank, in der Regeln betreffend die Installation von Komponenten in dem Flugzeug enthalten sind. Eine Verarbeitungseinheit konfiguriert auf Grundlage der Regeln und der kundenspezifischen Design- und Konfigurationsdaten ein Flugzeug und variiert dabei automatisch die kundenspezifischen Design- und Konfigurationsdaten, um das Design oder die Konfiguration des Flugzeugs zu verändern.

DE 10 2015 117 181 A1 offenbart einen Konfigurator zur Rekonfiguration einer Luftfahrzeugkonfiguration sowie ein entsprechendes Verfahren. Die Druckschrift geht von einer Ausgangskonfiguration eines Luftfahrzeugs aus, das für unterschiedliche Missionsprofile rekonfiguriert werden soll. Um die Ausgangskonfiguration zu rekonfigurieren, gibt ein Benutzer für ein Missionsprofil spezifische Rekonfigurationsparameter vor, auf Grundlage derer eine Recheneinheit automatisch alternative Luftfahrzeugkonfigurationen erstellt, die sich in der Kabineneinrichtung unterscheiden. Dabei kann gegenüber der Ausgangskonfiguration die Position und/oder die Anzahl von Komponenten in dem Luftfahrzeug verändert werden.

US 8 060 345 B2 offenbart ein computerimplementiertes Verfahren zur Gestaltung eines Innenabschnitt eines Flugzeugs, bei dem Objekte in dem Innenabschnitt des Flugzeugs virtuell angeordnet werden. Die Objekte haben neben physikalischen Geometrien, die ihren tatsächlichen Abmessungen entsprechen, auch nicht physikalische Geometrien, die auch als "bleib-außerhalb" (stay-out) Bereiche bezeichnet werden. Beispielsweise kann für einen Waschraum ein "bleib-außerhalb"-Bereiche definiert werden, in den die Tür des Waschraums öffnet. Weitere "bleib-außerhalb"-Bereiche des Waschraums sind für die Bewegung von Passagieren vorgesehen. Für diese "bleib-außerhalb"-Räume oder Bereiche werden Kollisionsregeln definiert, anhand derer entschieden werden kann, ob zwei "bleib-außerhalb" Bereiche sich überschneiden dürfen. Die Anordnung der Objekte in dem Flugzeuginnern erfolgt unter Berücksichtigung der Kollisionsregeln.

Die bisher bekannten Lösungen setzen somit im Wesentlichen auf den Wünschen des Kunden hinsichtlich der Ausstattung der Flugzeugkabine auf und versuchen diese so gut wie möglich unter Verwendung der zur Verfügung stehenden Komponenten zur Kabinenausstattung sowie der technischen Beschränkungen an die Anordnung der Komponenten in der Kabine zu erfüllen. Es handelt sich dabei um statische Anforderungen, mit denen keine Prozesse in der Kabine abgebildet werden können. Tatsächlich verändern sich die Anforderungen an eine und dieselbe Flugzeugkabine jedoch laufend während des Betriebs. Beispielsweise müssen während des Starts und der Landung völlig andere Anforderungen erfüllt werden, als während der Bewirtung der Passagiere im Reiseflug.

Vor diesem Hintergrund ist es eine Aufgabe der vorliegenden Erfindung, ein Verfahren und ein System anzugeben, mit dem ein begrenzter Raum, wie eine Flugzeugkabine, automatisch konfiguriert werden kann, wobei bei der Konfiguration nicht nur statische Anforderungen, sondern auch sich dynamisch ändernde Anforderungen berücksichtigt werden. Weiterhin ist es eine Aufgabe, ein Verfahren bereitzustellen, mit dem ermittelt werden kann, ob und inwieweit dieselben, sich zeitlich ändernden Anforderungen auf unterschiedliche verschiedene Flugzeugkabinen auswirken, die im Übrigen auf Grundlage verschiedener statischer Anforderungen erzeugt werden, die neben den bereits diskutierten Anforderungen beispielsweise auch unterschiedliche Flugbenzinbeladung, Frachtraumbeladung, Passagierbelegung und Creweinsatz beschreiben können. Schließlich ist es eine Aufgabe der vorliegenden Erfindung, ein Verfahren zur Herstellung einer Fahrzeugkabine anzugeben.

Die der Erfindung zugrundliegenden Aufgaben werden durch Verfahren gemäß den Ansprüchen 1, 12 und 13 sowie ein System gemäß Anspruch 14 gelöst.

Gemäß einem ersten Aspekt betrifft die Erfindung ein Verfahren zum automatisierten Auswählen einer Mehrzahl von strukturellen Elementen für einen begrenzten Raum und zum automatisierten Anordnen der Mehrzahl von strukturellen Elementen in dem begrenzten Raum. Die strukturellen Elemente werden von einem auf einer Datenverarbeitungseinrichtung ausgeführten Interpreter aus einer Vielzahl von Basiselementen, die in einer Elementdatenbank gespeichert sind, so ausgewählt und in dem begrenzten Raum so angeordnet, dass in logische Regeln umgesetzte Anforderungen an den begrenzten Raum erfüllt werden. Die Anforderungen an den begrenzten Raum umfassen Stellflächenanforderungen, Elementanforderungen und Positionsanforderungen. Jede Stellflächenanforderung definiert eine Position einer Stellfläche in dem begrenzten Raum und eine Abmessung der Stellfläche, auf der ein oder mehrere strukturelle Elemente positioniert werden können. Jede Elementanforderung definiert zumindest ein strukturelles Element, das in dem begrenzten Raum angeordnet werden muss. Jede Positionsanforderung schränkt eine Position zumindest eines strukturellen Elements in dem begrenzten Raum ein. Für jedes Basiselement sind in der Elementdatenbank zumindest räumliche Abmessungen des Basiselements hinterlegt. Zumindest eine Positionsanforderung nimmt für eine Mehrzahl von Zeitpunkten verschiedene Werte an, wobei jede Positionsanforderung für einen Zeitpunkt der Mehrzahl von Zeitpunkten einen Prozessschritt eines Prozesses darstellt. Der Interpreter ist so ausgestaltet, dass für jeden Zeitpunkt der Mehrzahl von Zeitpunkten, an dem die zumindest eine Positionsanforderung einen der verschiedenen Werte annimmt, dieselben strukturellen Elemente von dem Interpreter aus der Vielzahl von Basiselementen aus der Elementdatenbank ausgewählt und in dem begrenzten Raum angeordnet werden.

Mit anderen Worten ermöglicht das Verfahren ein kombiniertes und automatisiertes Auswählen und Anordnen von strukturellen Elementen in einem begrenzten Raum. Ein begrenzter Raum hat dabei vorbekannte und beschränkte Abmessungen, innerhalb derer die strukturellen Elemente angeordnet werden müssen. Ein Beispiel für einen begrenzten Raum ist die Passagierkabine eines Flugzeugs, in der eine Vielzahl von strukturellen Elementen angeordnet werden müssen. Die strukturellen Elemente, deren räumliche und körperliche Abmessungen ebenfalls bereits bekannt sind, können beispielsweise Monumente für Bordküchen oder Waschräume sein. Andere Beispiele für strukturelle Elemente sind Passagiersitze oder Sitze für Flugbegleiter, aber auch Bestandteile bzw. Ausstattungen der Monumente wie Trolleys, Öfen, Kaffeemaschinen oder dergleichen. Ein anderes Beispiel für einen begrenzten Raum sind die Bereiche eines Flugzeugs, in dem Leitungen zur Versorgung der Kabine angeordnet werden können. Die strukturellen Elemente umfassen in diesem Beispiel verschiedene Versorgungsleitungen und Entsorgungsleitungen, beispielsweise die Leitungen für die Versorgung mit Strom, Daten, Kühlmittel und Frischluft.

Im Rahmen des Verfahrens ist vorgesehen, dass für jeden begrenzten Raum eine Vielzahl von strukturellen Elementen vorgesehen ist, die grundsätzlich in dem begrenzten Raum angeordnet werden können. Diese strukturellen Elemente werden als Basiselemente bezeichnet und sind in einer Datenbank abgelegt, die für jedes strukturelle Element oder Objekt verschiedenste Varianten, Abwandelungen oder Unterformen aufweisen können. Beispielsweise können für ein Waschraummonument verschiedene Varianten in der Datenbank hinterlegt sein, die verschiedene Abmessungen aber auch verschiedene Eigenschaften aufweisen. Auch innerhalb einer Variante kann aus verschiedenen Untervarianten ausgewählt werden, die sich durch einen hierarchischen Aufbau der Datenbank ergeben. So kann beispielsweise bei einem Monument für eine Bordküche zwischen Varianten ausgewählt werden, die Staufächer und Arbeitsflächen oder lediglich Staufächer ohne Arbeitsfläche umfassen. Als Untervarianten kann beispielsweise vorgesehen sein, was in verschiedenen Fächern der Bordküche angeordnet werden kann, zum Beispiel, Öfen, Stauboxen, Kaffeemaschinen, Kühlschränke, und wie die unterschiedlichen Einbauten betrieben werden können. Ein weiteres Beispiel für eine Variante eines Monuments kann die Position des Zugangs zu einer Bordtoilette sein, die sich beispielswiese in der Position der Tür und der Art der Tür wiederspiegelt.

In der Datenbank sind neben den Eigenschaften der Basiselemente und den Verhältnissen von Basiselementen zueinander für jedes Basiselement auch die Abmessungen des jeweiligen Basiselements hinterlegt, so dass diese bei der Auswahl und beim Anordnen der strukturellen Elemente berücksichtigt werden können.

Aus dieser Datenbank wählt das auf einer Datenverarbeitungseinrichtung implementierte Verfahren mittels eines Interpreters, der auch als Reasoner bezeichnet werden kann, verschiedene strukturelle Elemente aus, die in dem begrenzten Raum angeordnet werden. Die Auswahl und Anordnung der Elemente erfolgt so, dass möglichst viele Anforderungen erfüllt werden, die an den begrenzten Raum gestellt werden. Die Anforderungen an den begrenzten Raum können aus den verschiedensten Bereichen stammen und verschiedenste Formen annehmen, die nachfolgend noch näher dargestellt werden. Allen Anforderungen ist jedoch gemein, dass sie zunächst in logische Regeln umgesetzt und damit vereinheitlicht werden. So können auf vorteilhafte Weise beispielsweise technische und regulatorische Beschränkungen und Vorgaben, räumliche Abmessungen von strukturellen Elementen und Anforderungen eines Kunden an eine Flugzeugkabine zu einem einheitlichen Satz von Anforderungen zusammengefasst und gleichermaßen bei der Auswahl und Anordnung der strukturellen Elemente in der Flugzeugkabine berücksichtigt werden.

Mittels des Interpreter wird für die Anforderungen oder den Satz von Anforderungen eine Lösung gesucht, die alle oder möglichst viele der Anforderungen erfüllt. Hierzu kann beispielsweise logische Programmierung verwendetet werden In diesem Fall stellen die Anforderungen an den begrenzten Raum Axiome dar, auf deren Grundlage ein Interpreter versucht, eine Lösung zu finden. In einem bevorzugten Ausführungsbeispiel wird Answer Set Programming als eine Form der logischen Programmierung verwendet, um die strukturellen Elemente auf Grundlage der Anforderungen aus der Elementdatenbank auszuwählen und in dem begrenzten Raum anzuordnen.

Die Anforderungen an den begrenzten Raum können in zumindest drei verschiedene Gruppen unterteilt werden: Stellflächenanforderungen, Elementanforderungen und Positionsanforderungen.

Stellflächenanordnungen betreffen die räumliche Aufteilung des begrenzten Raumes in Stellflächen, auf denen strukturelle Elemente angeordnet werden können. Der Begriff der Stellfläche kann dabei eine zweidimensionale Fläche bezeichnen, auf der ein strukturelles Element oder mehrere strukturelle Elemente angeordnet werden dürfen. Die Stellflächenanforderung kann aber auch eine dritte Dimension umfassen, also eine räumliche Einheit sein, so dass auch der für strukturelle Elemente zur Verfügung stehende Platz in der dritten Dimension berücksichtigt wird. Beispielsweise kann die Grundfläche einer Flugzeugkabine in Stellflächen unterteilt werden, auf denen Bordküchen oder Waschräume angeordnet werden können, die durch Gangflächen und Flächen für Sitze unterbrochen werden, in denen keine strukturellen Elemente bzw. nur Sitze angeordnet werden dürfen. Es handelt sich bei den Stellflächenanforderungen somit um die tatsächlichen, realen Abmessungen des begrenzten Raumes, der zur Verfügung steht, um darauf Objekte anzuordnen.

Elementanforderungen definieren strukturelle Elemente, die in dem begrenzten Raum angeordnet werden müssen oder sollen. Elementanforderungen können dabei sehr konkret sein, indem sie ein bestimmtes strukturelles Element erfordern, also beispielsweise einen bestimmten Waschraum oder ein bestimmtes Bordküchenelement, oder auch nur allgemein eine Kategorie von strukturellen Elemente definieren, wie beispielsweise eine allgemeine Bordküche, deren weitere Eigenschaften sich beispielsweise aus zusätzlichen Anforderungen ergeben können.

Schließlich schränken Positionsanforderungen die Position von strukturellen Elementen in dem begrenzten Raum ein. Positionsanforderungen können beispielsweise von einem Kunden vorgegebenen werden, der eine symmetrische Gestaltung des begrenzten Raumes möchte oder bestimmte Elemente auf bestimmten Stellflächen oder zumindest in bestimmten Bereichen eines begrenzten Raumes. Positionsanforderungen können aber auch durch Regularien vorgegeben sein, die beispielsweise Flugbegleitersitze an bestimmten Positionen in einer Flugzeugkabine notwendig machen. Auch können Positionsanforderungen durch die strukturellen Elemente selber vorgegeben werden. Beispielsweise kann ein strukturelles Element eine Stellfläche mit einer bestimmten Raumhöhe erfordern. Weiterhin können Positionsanforderungen durch die Ausgestaltung des begrenzten Raumes vorgegeben sein. So können beispielsweise strukturelle Elemente, die einen Wasseranschluss benötigen, nur dort angeordnet werden, wo ein Wasseranschluss vorgesehen ist. Schließlich werden die in der Elementdatenbank hinterlegten Abmessungen von Basiselementen auch zu Positionsanforderungen umgesetzt, da die Position eines Basiselements aufgrund seiner Abmessungen stets insoweit eingeschränkt wird, als dass es nur auf Stellflächen platziert werden kann, die ausreichend freien Platz zur Aufnahme des Basiselements bieten.

Erfindungsgemäß nimmt zumindest eine Positionsanforderung für eine Mehrzahl von Zeitpunkten verschiedene Werte an. Beispielsweise kann die Position eines Trolleys, der Teil einer Bordküche ist, für verschiedene Zeitpunkte verschiedene Werte annehmen, da der Trolley während der Bewirtung der Passagiere durch die Kabine bewegt wird. Auch eine Positionsanforderung für einen klappbaren Flugbegleitersitz kann für verschiedene Zeitpunkte verschiedene Werte annehmen, da der Flugbegleitersitz in eingeklapptem Zustand während des Fluges oder beim Ein- und Aussteigen aus dem Flugzeug andere Abmessungen aufweist als in ausgeklapptem Zustand während des Starts und der Landung. Jede sich zeitlich ändernde Positionsanforderung ist dabei ein Prozessschritt eines Prozesses, also beispielsweise Teil eines Bewirtungsprozesses, in dem Passagiere mit Mahlzeiten oder Getränken versorgt werden, oder Teil eines Prozesses, der eine Position eines Flugbegleiters in bestimmten Flugphasen, wie beispielsweise während des Starts und der Landung, beschreibt.

Der Interpreter ist so ausgestaltet, dass er für alle Zeitpunkt, für die für zumindest eine Positionsanforderung ein Wert definiert ist, die gleichen strukturellen Elemente aus der Datenbank auswählt und in dem begrenzten Raum anordnet. Mit anderen Worten erfolgt die Auswahl der strukturellen Elemente aus den Basiselementen für alle Zeitpunkte gemeinsam, die Anordnung der Elemente kann jeden für jeden Zeitpunkt unterschiedlich sein, sofern die strukturellen Elemente beweglich sind.

Auswahl und Anordnung der Elemente erfolgen dabei unter Berücksichtigung von einer Vielzahl von Anforderungen, die verschiedenste Ursprünge haben. Da jedoch stets die Abmessungen des begrenzten Raumes bzw. der Stellflächen innerhalb des Raumes sowie die Abmessungen der strukturellen Elemente und die die Anforderungen an die Position der strukturellen Elemente berücksichtigt werden, ist es auf vorteilhafte Weise möglich, die räumliche Anordnung der strukturellen Elemente unter Berücksichtigung einer Vielzahl von Anforderungen zu bestimmen. Indem auch zeitliche veränderliche Positionsanforderungen berücksichtigt werden, eröffnet das vorliegende Verfahren zudem die Möglichkeit, auch Prozesse, die sich in der Änderung von Positionsanforderungen wiederspiegeln, innerhalb des beschränkten Raumes bei der Anordnung der strukturellen Elemente automatisch zu berücksichtigen.

Die erzeugte Anordnung von Basiselemente in dem begrenzten Raum kann beispielsweise durch einen Nutzer untersucht werden, um mögliche Defizite zu erkennen. Werden Defizite erkannt, können Anforderungen geändert werden, um diese zu überwinden. Die veränderten Anforderungen werden erneut in logische Regeln umgesetzt, und es wird mittels des Interpreters eine neue Auswahl und Anordnung von Basiselementen für den begrenzten Raum vorgenommen, um zu überprüfen, ob die vorgenommenen Änderungen geeignet sind, um die Defizite zu überwinden.

Die Veränderungen können darin bestehen, dass Prozesse angepasst werden. Hierzu können beispielsweise die Zeitpunkte angepasst werden, für die bestimmte Positionsanforderungen definiert wurden, Positionsanforderungen für zusätzliche Zeitpunkte definiert werden, bestehende Positionsanforderungen gestrichen werden oder es werden für bestimmte Zeitpunkte alternative Positionsanforderungen definiert. Alternativ ist es auch denkbar, Elementanforderungen oder Stellflächenanforderungen anders zu definieren, um in einem vorwärts gerichteten Prozess die Anordnungen der Basiselemente in dem begrenzten Raum insgesamt zu verändern und die Auswirkungen dieser Änderungen auf die Prozesse zu überprüfen.

In einer beispielhaften Ausführungsform kann die Datenbank in Form einer Ontologie aufgebaut werden, also eine sprachlich gefasste und formal geordnete Darstellung der strukturellen Elemente sein, die nicht nur von einer Maschine sondern vorzugsweise auch von einem Menschen lesbar sind. Eine solche Ontologie kann beispielsweise sieben geordnete Ebenen aufweisen, auf denen die strukturellen Elemente angeordnet sind. Sechs der Ebenen werden dabei beispielsweise zur Beschreibung der körperlichen Eigenschaften und Varianten der verschiedenen strukturellen Elemente verwendet, während die siebte Ebene verwendet wird, um zeitliche Verläufe von Positionsanforderungen abzubilden.

In einer bevorzugten Ausführungsform wird nachdem die automatisierte Auswahl und Anordnung der Mehrzahl von strukturellen Elementen für den begrenzten Raum erfolgt ist, mittels der Datenverarbeitungseinrichtung zumindest ein Maß bestimmt, das geeignet ist, um die erfolgte Auswahl und Anordnung der Mehrzahl von strukturellen Elementen in dem begrenzten Raum zu bewerten. Das zumindest eine Maß umfasst weiter bevorzugt einen Schwerpunkt des begrenzten Raums.

Die Bestimmung eines oder mehrerer Maße kann verwendet werden, um die erfolgte Auswahl und Anordnung der strukturellen Elemente in dem beschränkten Raum in verschiedener Hinsicht zu bewerten und als Grundlage für eine Optimierung und Weiterentwicklung bzw. Anpassung der Anforderungen dienen, die insbesondere auch automatisch erfolgen kann. Beispielsweise kann ein Maß wie der Schwerpunkt dazu verwendet werden, die Tragfähigkeit der Struktur zu überprüfen, die den begrenzten Raum aufnimmt. Es können aber auch solche Maße bestimmt werden, mit denen die Auswahl und Anordnung der strukturellen Elemente aus wirtschaftlichen Aspekten bewertet werden kann, beispielsweise können die Kosten für eine bestimmte Anordnung ermittelt werden. Solche Maße werden auch als Leistungskennzahlen oder Key-Performance-Indicators (KPI) bezeichnet. Die bestimmten Maße können insbesondere zum Erkennen von Defiziten verwendet werden.

In einer weiter bevorzugten Ausführungsform umfassen die Anforderungen an den begrenzten Raum Betriebsanforderungen. Jede Betriebsanforderung gibt den Betrieb zumindest eines strukturellen Elements vor. Zumindest eine Betriebsanforderung nimmt für eine Mehrzahl von Zeitpunkten verschiedene Werte an. Jede Betriebsanforderung stellt für einen Zeitpunkt der Mehrzahl von Zeitpunkten einen Prozessschritt eines Prozesses dar. Der Interpreter ist so ausgestaltet, dass auch für jeden Zeitpunkt der Mehrzahl von Zeitpunkten, an dem die zumindest eine Betriebsanforderung einen Wert der verschiedene Werte annimmt und an dem die zumindest eine Positionsanforderung einen der verschiedenen Werte annimmt, dieselben strukturellen Elemente von dem Interpreter aus der Vielzahl von Basiselementen aus der Elementdatenbank ausgewählt und in dem begrenzten Raum angeordnet werden.

Betriebsanforderungen können beispielsweise vorgeben, welche Funktionen ein bestimmtes strukturelles Element oder allgemein von dem begrenzten Raum und damit insgesamt von den in dem Raum angeordneten strukturellen Elementen zur Verfügung gestellt werden sollen. Auch Betriebsanforderungen können für verschiedene Zeitpunkte unterschiedliche Werte annehmen und damit verschiedene Prozesse abbilden. Beispielsweise können Öfen zum Erwärmen verschiedener Mahlzeiten in einer Bordküche verwendet werden oder Stellflächen können im Laufe der Zeit zum Abstellen unterschiedlicher Gegenstände verwendet werden. Denkbar ist auch als unterschiedliche Betriebsanforderung beispielsweise die Verwendung eines Waschraums als WC, Wickelraum und Dusche, wobei nicht konkret angefordert werden muss, dass ein Waschraum diese Funktionen bereitstellt, sondern lediglich Betriebsanforderungen definiert werden, die sicherstellen, dass zu unterschiedlichen Zeitpunkten die unterschiedlichen Betriebsarten bzw. Funktionen auf irgendeine Weise in dem beschränkten Raum bereitgestellt werden. Dies hat den Vorteil, dass der Nutzer des Verfahrens nicht die Verwendung bestimmter struktureller Komponenten vorgeben muss, sondern vielmehr das Verfahren aufgrund der Anforderungen geeignete Komponenten auswählt. Damit hängt die Konfiguration nicht vom Vorstellungsvermögen und den Kenntnissen der Person ab, die den Raum konfiguriert, sondern wird auf Grundlage des technisch Möglichen und im Rahmen der räumlich und zeitlich vorgegebenen Beschränkungen automatisch umgesetzt.

In einer bevorzugten Ausführungsform liegen die Stellflächen innerhalb von äußeren Abmessungen des begrenzten Raums und werden durch eine oder mehrere Sperrflächen eingeschränkt, auf denen nie oder zeitweise keine strukturellen Elemente, Passagiere, Crew und andere Ausrüstungsgegenstände positioniert werden dürfen. Beispielsweise können Sperrflächen Gang- und Türbereiche einer Flugzeugkabine sein.

Es ist weiter bevorzugt, wenn zumindest eine Stellflächenanforderung für eine Mehrzahl von Zeitpunkten verschiedene Abmessung einer Stellfläche definiert, auf der ein oder mehrere strukturelle Elemente positioniert werden können. Beispielsweise kann während des Starts und während der Landung eines Flugzeugs ein Gang keine Stellfläche sein. Während des Reiseflugs kann der Gang jedoch als Stellfläche definiert werden, so dass er zur Positionierung von Trolleys verwendet werden kann.

Die Anforderungen an den begrenzten Raum umfassen in einer bevorzugten Ausführungsform zudem Personalanforderungen und Tätigkeitsanforderungen. Jede Personalanforderung definiert die Anwesenheit zumindest einer Person in dem begrenzten Raum definiert und gibt Abmessungen vor, die die zumindest eine Person in dem begrenzten Raum einnimmt. Jede Tätigkeitsanforderung definiert die Tätigkeit zumindest einer in dem begrenzten Raum anwesenden Person in Bezug auf zumindest ein strukturelles Element. Zumindest eine Tätigkeitsanforderung nimmt für eine Mehrzahl von Zeitpunkten verschiedene Werte an, wobei jede Tätigkeitsanforderung für einen Zeitpunkt der Mehrzahl von Zeitpunkten einen Prozessschritt eines Prozesses darstellt. Der Interpreter ist so ausgestaltet, dass auch für jeden Zeitpunkt der Mehrzahl von Zeitpunkten, an dem die zumindest eine Tätigkeitsanforderung einen Wert der verschiedenen Werte annimmt, dieselben strukturellen Elemente von dem Interpreter aus der Vielzahl von Basiselementen aus der Elementdatenbank ausgewählt und in dem begrenzten Raum angeordnet werden.

Durch die Aufnahme von Personal- und Tätigkeitsanforderungen ist es auf vorteilhafte Weise möglich, auch den Einsatz von Personal und die Tätigkeiten des Personals bei der Auswahl und Anordnung von strukturellen Elementen in dem beschränkten Raum zu berücksichtigen. Da jeder Person Abmessungen zugeordnet sind, kann beispielsweise sichergestellt werden, dass bei der Durchführung bestimmter Prozesse bzw. bestimmter Prozessschritte auch ausreichend Platz für eine Person ist, die diese Prozessschritte durchführt bzw. überwacht.

Werden in der ermittelten Auswahl und Anordnung von Basiselementen für den begrenzten Raum Defizite festgestellt, so kann auf diese Defizite beispielsweise auch reagiert werden, in dem Personal- und Tätigkeitsanforderungen angepasst werden. So kann durch veränderte Personalanforderungen in einer beispielhaften Ausführungsform eine Flugzeugkabinencrew in lokalen Bereichen verstärkt oder reduziert werden, es können Tätigkeiten an andere Orte verschoben werden, falls das weitere Personal entsprechend qualifiziert ist und einzelne Personal- oder Tätigkeitsanforderungen können für andere Zeitpunkte definiert, komplett gestrichen oder neu hinzugefügt werden, um nur einige Beispiele zu nennen.

In einem konkreten Beispiel könnte ein Bediener bei der Auswertung einer erzeugten Auswahl von Basiselementen in einem begrenzten Raum in Form einer Flugzeugkabine feststellen, dass während eines Kurzstreckenfluges nicht ausreichend Zeit vorhanden ist, um in einem ersten Bereich der Kabine vor einer Tür alle Passagiere aus einem Trolley mit Mahlzeiten zu versorgen, aber mehr als ausreichend Zeit vorhanden ist, um die Passagiere in einem zweiten Bereich hinter der selben Tür mit Mahlzeiten aus einem anderen Trolley zu versorgen. Um dieses Defizit zu beheben, könnten beispielsweise mittels geänderter Anforderungen Sitze aus dem ersten Bereich in den zweiten Bereich verschoben werden.

Auf vorteilhafte Weise umfasst das Definieren der Stellflächenanforderungen ein Ermitteln von Abmessungen des begrenzten Raumes.

In einer bevorzugten Ausführungsform ist der begrenzte Raum eine Fahrzeugkabine, vorzugsweise eine Kabine eines Passagierflugzeugs. Dabei ist es bevorzugt, wenn die Elementanforderungen zumindest eine erste Anzahl von Passagiersitzplätzen in der Fahrzeugkabine sowie eine zweite Anzahl von Kabinenpersonalsitzplätzen umfasst. Das Maß ist ein Anteil der Passagiersitzplätze, die in einem Sichtfeld von Kabinenpersonalsitzplätzen liegen. Auf diese Weise kann auf vorteilhafte Weise überprüft werden, ob die entsprechenden regulatorischen Vorschriften eingehalten werden.

Weisen die Elementanforderungen zumindest eine erste Anzahl von Passagiersitzplätzen in der Fahrzeugkabine auf, umfassen die Anforderungen an den begrenzten Raum in einer bevorzugten Ausführungsform Passagieranforderungen, wobei jede Passagieranforderung die Anwesenheit zumindest eines Passagiers in dem begrenzten Raum definiert, Abmessungen vorgibt, die der zumindest eine Passagier in dem begrenzten Raum einnimmt, und Beschränkungen definiert, auf welchen Passagiersitzplätzen in dem begrenzten Raum der zumindest eine Passagier angeordnet werden darf.

Die Passagieranforderungen ermöglichen es auf vorteilhafte Weise, die Anzahl und Verteilung von Passagieren in einer Flugzeugkabine zu berücksichtigen. Die Verteilung der Passagiere kann sich beispielsweise auf verschiedene Maße auswirken oder zu berücksichtigen sein, wenn einzelne Schritte von Prozessen betrachtet werden. So wirkt sich die Anzahl der Passagiere und deren Verteilung in der Kabine beispielsweise auf die Zeit auf, die für das Servieren von Mahlzeiten benötigt wird.

In einem zweiten Aspekt wird das der Erfindung zugrundeliegende Problem durch ein Verfahren zur Evaluierung eines Prozesses für eine Mehrzahl von verschiedenen Konfigurationen eines begrenzten Raumes gelöst, bei dem für jede Konfiguration der Mehrzahl von verschiedenen Konfiguration ein Satz von zumindest teilweise unterschiedlichen Anforderungen für den gleichen begrenzten Raum definiert ist. Jeder Satz von Anforderungen umfasst eine Mehrzahl von Anforderungen, die dieselben Prozessschritte zumindest eines zu evaluierenden Prozesses darstellen. Für jede Konfigurationen des begrenzten Raumes wird eine Anordnung von strukturellen Elementen in dem begrenzten Raum bestimmt, indem das Verfahren zum automatisierten Auswählen einer Mehrzahl von strukturellen Elementen für einen begrenzten Raum und automatisierten Anordnen der Mehrzahl von strukturellen Elementen in dem begrenzten Raum nach einer der vorstehenden Ausführungsformen, bei dem zumindest ein Maß bestimmt wird, unter Verwendung des Satzes von Anforderungen, der für die jeweilige Konfiguration definiert wurde, durchgeführt wird. Zur Evaluierung des Prozesses wird für jede Konfigurationen des begrenzten Raumes das zumindest eine Maß bestimmt, wobei für alle Konfigurationen des begrenzten Raumes zumindest ein einheitliches Maß bestimmt wird.

Mit anderen Worten wird gemäß dem zweiten Aspekt das Verfahren zur Auswahl und Anordnung von strukturellen Elementen für eine und denselben begrenzten Raum unter Berücksichtigung verschiedene Sätze von Anforderungen durchgeführt. Die Sätze von Anforderungen können dabei beispielsweise verschiedene Nutzungen desselben Raumes abbilden. Beispielsweise kann bei einer Flugzeugkabine ein erster Anforderungssatz die Verwendung des Flugzeugs auf innereuropäischen Strecken beschreiben, ein zweiter Anforderungssatz die Verwendung des Flugzeugs auf amerikanischen Verbindungen zwischen Ost- und Westküste und ein dritter Anforderungssatz die Verwendung des Flugzeugs für den Charterbetrieb.

Allen Anforderungssätzen ist jedoch gemein, dass sie zumindest die Prozessschritte eines Prozesses umfassen, der in allen Varianten durchgeführt werden soll. Da für alle Sätze von Anforderungen bzw. den darauf folgenden Konfigurationen das gleiche Maß bestimmt wird, kann auf vorteilhafte Weise die Auswirkung von neuen Prozessen auf eine Vielzahl von verschiedenen Nutzungen des gleichen begrenzten Raumes überprüft und bewertet werden.

In einem weiteren Aspekt wird das der Erfindung zugrunde liegende Problem durch ein Verfahren zur Herstellung einer Fahrzeugkabine gelöst, bei dem eine Mehrzahl von strukturellen Elementen in die Fahrzeugkabine eingebaut wird. Das Verfahren umfasst die Schritte Erfassen von äußeren Abmessungen der Fahrzeugkabine, innerhalb derer die Mehrzahl von strukturellen Elementen angeordnet werden muss, Durchführung eines Verfahrens gemäß einer der beschriebenen Ausführungsformen, bei denen der begrenzte Raum eine Fahrzeugkabine ist, zur Ermittlung einer automatisierten Auswahl der Mehrzahl von strukturellen Elementen zum Einbau in die Fahrzeugkabine und zur automatisierten Bestimmung der Anordnung der Mehrzahl von strukturellen Elementen zum Einbau in der Fahrzeugkabine, wobei die Stellflächenanforderungen unter Berücksichtigung der erfassten äußeren Abmessungen der Fahrzeugkabine definiert werden, und Einbau der Mehrzahl von mittels des Verfahrens ausgewählten strukturellen Elemente entsprechend der mittels des Verfahrens ermittelten Anordnung in der Fahrzeugkabine.

Die Vorteile der auf diese Weise hergestellten Fahrzeugkabine entsprechen den Vorteilen des Verfahrens, das zur Auswahl und zur Anordnung der strukturellen Elemente verwendet wird.

Schließlich wird das der Erfindung zugrunde liegende Problem durch ein System zum automatisierten Auswählen einer Mehrzahl von strukturellen Elementen für einen begrenzten Raum und zum automatisierten Anordnen der Mehrzahl von strukturellen Elementen in dem begrenzten Raum gelöst. Das System umfasst eine Datenverarbeitungseinrichtung und einen Datenspeicher. Das System ist dazu eingerichtet, ein Verfahren nach einer der vorhergehenden Ausführungsformen auszuführen, wobei die Elementdatenbank in dem Datenspeicher gespeichert ist.

Nachfolgend wird die Erfindung bezugnehmend auf die Zeichnung näher erläutert. Darin zeigen
- Figur 1: ein Ausführungsbeispiel eines begrenzten Raumes mit Stellflächen,
- Figur 2: Ausführungsbeispiele von Basiselementen für einen begrenzten Raum,
- Figur 3: eine Ausführungsbeispiel eines begrenzten Raumes mit darin angeordneten strukturellen Elementen,
- Figur 4: eine Ablaufdiagramm eines Ausführungsbeispiels eines Verfahrens zur Auswahl und zum Anordnen von strukturellen Elementen in einem begrenzten Raum,
- Figur 5: ein Ablaufdiagramm eines Ausführungsbeispiels eines Verfahrens zur Evaluierung eines Prozesses für eine Mehrzahl von verschiedenen Konfigurationen eines begrenzten Raums,
- Figur 6: ein Ablaufdiagramm eines Ausführungsbeispiels eines Verfahrens zur Herstellung einer Fahrzeugkabine und
- Figur 7: ein Ausführungsbeispiel eines Systems zum automatisierten Auswählen von strukturellen Elementen für einen begrenzten Raum und zum Anordnen der strukturellen Elemente in dem begrenzten Raum.

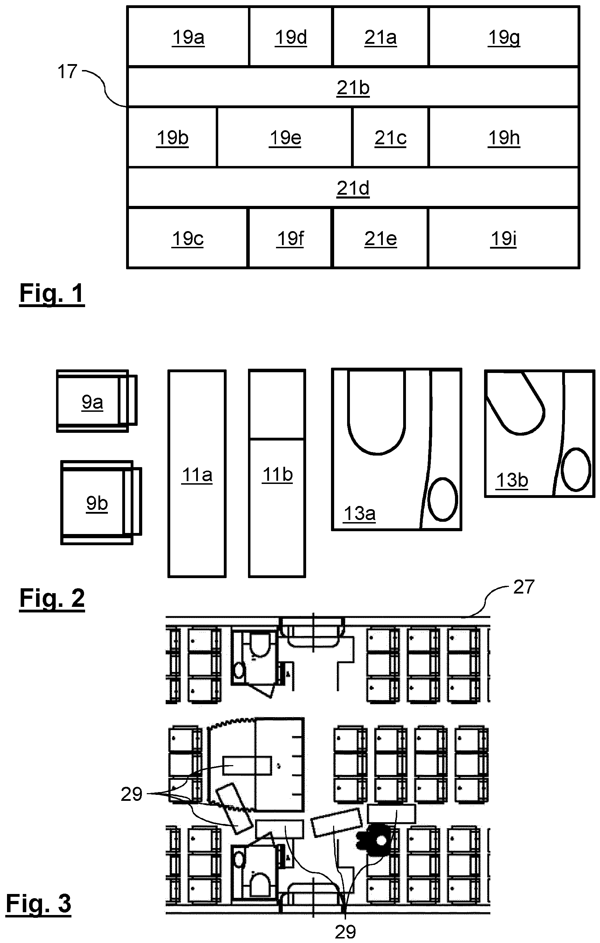

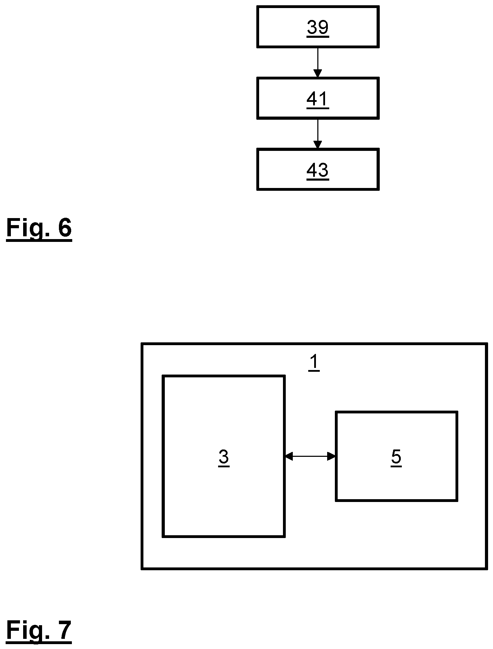

Nachfolgend wird zunächst bezugnehmend auf die Figuren 1 bis 4 ein Ausführungsbeispiel eines Verfahrens zur Auswahl und zum Anordnen von strukturellen in einem begrenzten Raum beschrieben, das mittels eines in Figur 7 gezeigten Systems 1 durchgeführt wird. Das System umfasst eine Datenverarbeitungsvorrichtung 3 in Form eines Prozessors sowie einen Speicher oder Datenspeicher 5. In dem vorliegenden Ausführungsbeispiel handelt es sich bei dem begrenzten Raum um die Kabine eines Passagierflugzeugs, also eine Passagierkabine eines Fahrzeugs oder eine Fahrzeugkabine.

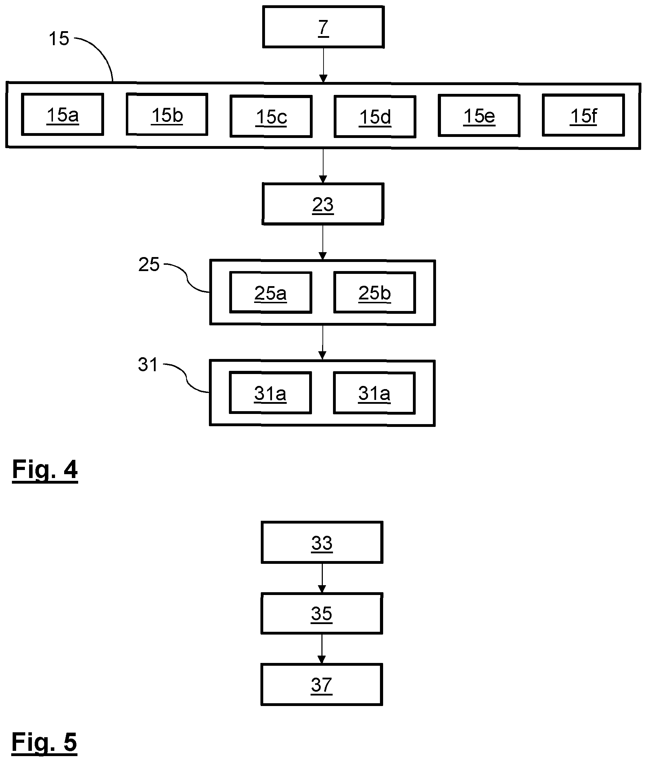

In einem ersten Schritt 7 des Verfahrens, dessen Ablauf schematisch in Figur 4 gezeigt ist, wird zunächst eine Elementdatenbank im Datenspeicher 5 des Systems 1 bereitgestellt. In der Elementdatenbank ist eine Vielzahl von Basiselementen gespeichert, aus denen im Rahmen des Verfahrens verschiedene strukturelle Elemente ausgewählt und in einem begrenzten Raum angeordnet werden.

Beispiele für Basiselemente 9a, 9b, 11a, 11b, 13a, 13b sind in Figur 2 gezeigt. Die Basiselemente 9a und 9b sind Sitze 9a, 9b mit unterschiedlichen Abmessungen, die Basiselemente 11a und 11b sind zwei Trolleys 11a, 11b für eine Bordküche mit identischen Abmessungen, aber unterschiedlichem Funktionsumfang und die Basiselemente 13a, 13b sind Waschräume 13a, 13b mit unterschiedlichen Abmessungen und unterschiedlichem Funktionsumfang. Beispielsweise handelt es sich bei dem schmaleren Sitz 9a um einem Sitz für die Economy-Klasse und bei dem breiteren Sitz 9b um einen Sitz für die Business-Klasse. Einer der beiden Trolleys 11a ist für Abfall vorgesehen, während der andere Trolley 11b Getränke umfasst. Die Waschräume 13a, 13b unterscheiden sich insbesondere darin, dass das der eine Waschraum 13a über ein reguläres WC verfügt, während der andere Waschraum 13b lediglich über ein Urinal verfügt.

Diese Basiselemente 9a, 9b, 11a, 11b, 13a, 13b sind mit nach ihrer Art geordnet und zusammen mit ihren Funktionen und Abmessungen in der Elementdatenbank gespeichert, die im Speicher 5 des Systems 1 abgelegt ist.

In einem zweiten Schritt 15 werden verschiedenste Anforderungen definiert, die von den in dem begrenzten Raum anzuordnenden strukturellen Elementen erfüllt werden müssen. In dem vorliegenden Ausführungsbeispiel werden in verschiedenen Teilschritten 15a bis 15f des zweiten Schritts 15 unter anderem Stellflächenanforderungen (Teilschritt 15a), Elementanforderungen (Teilschritt 15b), Positionsanforderungen (Teilschritt 15c), Betriebsanforderungen (Teilschritt 15d), Personalanforderungen (Teilschritt 15e) und Tätigkeitsanforderungen (Teilschritt 15f) definiert.

Bei der Definition von Stellflächenanforderungen in Teilschritt 15a werden, wie nachfolgend bezugnehmend auf die schematische Darstellung einer Flugzeugkabine 17 in Figur 1 näher erläutert wird, zunächst die äußeren Abmessungen des begrenzten Raumes 17 ermittelt, beispielsweise ausgemessen oder Zeichnungen entnommen, für den strukturelle Elemente 9a, 9b, 11a, 11b, 13a, 13b ausgewählt werden sollen und in dessen begrenzten Abmessungen die Elemente 9a, 9b, 11a, 11b, 13a, 13b angeordnet werden müssen.

In dem begrenzten Raum 17 werden nachfolgend Stellflächen 19a bis 19i festgelegt und deren Abmessungen bestimmt, in denen strukturelle Elemente 9a, 9b, 11a, 11b, 13a, 13b angeordnet werden dürfen. Wie man Figur 1 unmittelbar entnehmen kann, haben die Stellflächen 19a bis 19i unterschiedliche Abmessungen. Zwischen den Stellflächen 19a bis 19i sind Sperrflächen 21a bis 21e angeordnet, auf denen keine strukturellen Elemente 9a, 9b, 11a, 11b, 13a, 13b permanent angeordnet werden dürfen.

Einige Stellflächenanforderungen sind nicht dauerhaft, sondern nehmen für verschiedene Zeitpunkte verschiedenen Werte an. So dürfen beispielsweise auf den Sperrflächen 21b, 21c und 21d beispielsweise während des Starts und der Landung keine strukturellen Elemente angeordnet werden. Während des Reiseflugs dürfen hier jedoch strukturelle Elemente 9a, 9b, 11a, 11b, 13a, 13b wie beispielsweise Trolleys 11a, 11b temporär angeordnet werden. Die Sperrflächen 21b, 21c und 21d können daher beispielsweise für alle Zeitpunkte außerhalb des Reiseflugs, also während des Rollens, beim Start und bei der Landung, als Stellflächen ohne Fläche definiert werden. Während des Reiseflugs wird den Sperrfläche 21b, 21c und 21d jeweils eine endliche Abmessung zugewiesen, die für die temporäre Anordnung von strukturellen Elementen 9a, 9b, 11a, 11b, 13a, 13b verwendet werden kann.

Im zweiten Teilschritt 15b werden Elementanforderungen definiert, die die schließlich in der Kabine 17 angeordneten strukturellen Elemente erfüllen müssen. Eine Elementanforderung kann beispielsweise die Anzahl der Waschräume pro Sitzplatz oder auch ein bestimmter Typ einer Bordküche oder eines Trolleys für eine Bordküche sein. Elementanforderungen nehmen für unterschiedliche Zeitpunkte stets den gleichen Wert an, da zu jedem Zeitpunkt alle strukturellen Elemente innerhalb des begrenzten Raumes angeordnet sein müssen.

Im dritten Teilschritt 15c werden Positionsanforderungen für verschiedenen strukturelle Elemente 9a, 9b, 11a, 11b, 13a, 13b definiert. Eine Positionsanforderung kann beispielsweise eine symmetrische Ausgestaltung der Kabine 17 relativ zu einer Längsachse der Kabine 17 sein, aber auch eine konkrete Anforderung, dass auf der Stellfläche 19e eine Bordküche anzuordnen ist. Auch Positionsanforderungen umfassen zeitabhängige Elemente. Beispielsweise kann für einen Trolley 11a, 11b eine zeitliche Abfolge von Positionen definiert werden, die der Trolley 11a, 11b während einzelner Prozessschritte eines Prozesses, bei dem Passagiere mit einer Mahlzeit versorgt werden, einnehmen muss.

Im vierten Teilschritt 15d werden Betriebsanforderungen definiert, die vorgeben, wie eines oder mehrere der nach Abschluss des Verfahrens in der Kabine 17 angeordneten strukturellen Elemente 9a, 9b, 11a, 11b, 13a, 13b betrieben werden können. Beispielsweise kann festgelegt werden, dass es möglich sein muss, zu einem bestimmten Zeitpunkt Brötchen aufzuwärmen oder zumindest einer der Waschräume muss als Wickelraum nutzbar sein. Auch diese Anforderungen können für verschiedene Zeitpunkte verschiedene Werte annehmen.

Im fünften und sechsten Teilschritt 15e und 15f werden Personal- und Tätigkeitsanforderungen festgelegt. Diese geben zum einen vor, wie viel Personal in dem begrenzten Raum anwesend sein muss, und zum anderen, welche Tätigkeiten das Personal zu welchen Zeitpunkten ausüben muss. Beispielsweise kann festgelegt werden, dass eine bestimmte Person zu einem bestimmten Zeitpunkt eine bestimmte Tätigkeit durchführen muss. Es ist aber auch möglich, lediglich festzulegen, dass eine bestimmte Tätigkeit zu einem bestimmten Zeitpunkt durchgeführt werden muss, ohne eine konkrete Person festzulegen, die die Tätigkeit durchführt.

Jede Person ist mit einer bestimmten Abmessung verknüpft, die diese Person während der Durchführung von bestimmten Tätigkeiten einnimmt, so dass auch der vom Personal benötigte Raum berücksichtigt werden kann.

Der erste Schritt 7 und die Teilschritte 15a bis 15f des zweiten Schritts 15 können in beliebiger Reihenfolge oder auch parallel zueinander durchgeführt werden.

In einem dritten Schritt 23 werden sämtliche Anforderungen in logische Regeln übersetzt oder umgesetzt, um das Anordnungsproblem, das eine Vielzahl von technischen und anderen Anforderungen erfüllen muss, in ein logisches Problem zu überführen. Im vierten Schritt 25 wird mittels eines Interpreters, der in dem vorliegenden Ausführungsbeispiel auf Answer Set Programming beruht, eine Auswahl (Teilschritt 25a) unter den Basiselementen 9a, 9b, 11a, 11b, 13a, 13b in der Datenbank getroffen und die ausgewählten Elemente 9a, 9b, 11a, 11b, 13a, 13b in der Kabine 17 angeordnet (Teilschritt 25b). In Figur 4 sind die Teilschritt 25a und 25b getrennt dargestellt. Tatsächlich sind sie aber untrennbar miteinander verbunden, da aufgrund der Definition der Anforderungen als logische Regeln stets gleichzeitig die Auswahl eines Objektes mit der Anordnung des Objektes verbunden ist.

Der Interpreter ist dabei so ausgestaltet, dass er für unterschiedliche Zeitpunkte stets versucht alle Anforderungen zu erfüllen, dabei aber für alle Zeitpunkte die gleichen strukturellen Elemente 9a, 9b, 11a, 11b, 13a, 13b auswählt, aber auf unterschiedliche Stellflächen 19a bis 19i verteilt, wenn sie beweglich sind oder in unterschiedliche Betriebszustände versetzt. Ein Beispiel für eine Mittels des Verfahrens erzeugte Auswahl von strukturellen Elementen und ihre Anordnung in einer Kabine 27 ist in Figur 3 gezeigt. Exemplarisch wird dabei für einen Trolley 29 gezeigt, wie dieser zu verschiedenen Zeitpunkten an verschiedenen Orten in der Kabine 27 angeordnet ist.

Das Verfahren ermöglicht damit auf vorteilhafte Weise, automatisch auf Grundlage einer Vielzahl von Anforderungen an eine Fahrzeugkabine Elemente auszuwählen und in der Kabine anzuordnen. Dabei werden nicht nur statische Anforderungen und Wünsche des Kunden berücksichtigt, sondern es ist auch möglich, Prozesse abzubilden, um sie direkt bei der Planung der Kabine zu berücksichtigen.

In einem abschließenden Schritt werden in dem vorliegenden Ausführungsbeispiel schließlich zwei Maße für die gefunden Kabinenanordnung bestimmt, mit denen die Kabinenanordnung bewertet werden kann. Beispielsweise kann in einem ersten Teilschritt 31a der Schwerpunkt der gefundenen Kabinenanordnung berechnet. Die Position des Schwerpunkts der Kabine kann Aufschluss über das Flugverhalten des Flugzeugs geben. Diese Maß ist insbesondere dazu geeignet, um Schlüsse über die Vor- und Nachteile von bestimmten Kabinenanordnungen ziehen zu können, verschiedene Kabinenanordnungen miteinander zu vergleichen und Verbesserungen an den Kabinenanordnungen vorzunehmen, in dem automatisch oder manuell Anforderungen angepasst und neue Kabinenanordnungen berechnet werden.

Als zweites Maß kann beispielsweise berechnet werden, wie hoch der Anteil der Passagiere ist, die bei Start und Landung von Sitzplätzen für Flugbegleitern aus gesehen werden können. Auf diese Weise kann unmittelbar überprüft werden, ob bestimmte regulatorische Anforderungen erfüllt werden.

In Figur 5 ist schematisch ein Ablaufdiagramm für ein Verfahren zur Evaluierung eines Prozesses für eine Mehrzahl von verschiedenen Konfigurationen eines begrenzten Raumes, einer Flugzeugkabine, dargestellt. Dabei wird zunächst in einem ersten Schritt 33 für jede Konfiguration der Kabine ein Satz von unterschiedlichen Anforderungen erstellt, die für die gleiche Kabine gelten sollen. Jeder Satz von Anforderungen enthält jedoch dieselben Prozessschritte des zu evaluierenden Prozesses, beispielsweise eines Bewirtungsprozesses, bei dem ein Trolley durch eine Kabine geschoben wird.

In einem zweiten Schritt 35 wird für jede Konfiguration, sprich jeden Satz von Anforderungen, eine Anordnung von strukturellen Elementen in der Kabine, also eine Kabinenanordnung, bestimmt, in dem unter Verwendung des jeweiligen Anforderungssatzes das bezugnehmend auf die Figuren 1 bis 4 beschriebene Verfahren durchgeführt wird. Zur Evaluierung des Prozesses wird schließlich im dritten Schritt 37 für jede Konfigurationen der Kabine zumindest ein einheitliches Maß bestimmt, mit dem die Kabinenanordnungen bewertet werden können. Beispielsweise können hierzu Maße wie die Kosten einer Kabinenanordnung bestimmt werden. Es ist aber beispielsweise auch möglich, eine Zeit zu bestimmen, die für die Durchführung des zu evaluierenden Prozesses benötigt wird.

Damit ermöglicht das Verfahren auf vorteilhafte Weise die Auswirkung neuer Prozesse auf unterschiedliche Konfigurationen von Kabinen unmittelbar zu ermitteln, ohne dass hierfür aufwendige manuelle Planungen notwendig sind. Daher können bereits in einem frühen Stadium der Entwicklung mit geringem Kostenaufwand überprüft werden, ob ein Prozess umgesetzt werden kann.

Schließlich zeigt Figur 6 ein Ablaufdiagramm eines Verfahrens zur Herstellung einer Flugzeugkabine 17, 27, bei dem eine Mehrzahl von strukturellen Elementen 9a, 9b, 11a, 11b, 13a, 13b in die Flugzeugkabine 17, 27 eingebaut wird. Dabei werden in einem ersten Schritt 39 äußere Abmessungen der Fahrzeugkabine 17, 27 erfasst, innerhalb derer die Mehrzahl von strukturellen Elementen 9a, 9b, 11a, 11b, 13a, 13b angeordnet werden können. Danach wird in einem zweiten Schritt 41 das bezugnehmend auf die Figuren 1 bis 4 erläuterte Verfahren für die Kabine 17, 27 durchgeführt. Dabei werden automatisch strukturelle Elemente 9a, 9b, 11a, 11b, 13a, 13b zum Einbau in die Kabine 17, 27 ausgewählt und es wird von der Datenverarbeitungseinrichtung 3 bestimmt, wo die ausgewählten strukturellen Elemente in die Kabine 17, 27 eingebaut werden. Zumindest die Stellflächenanforderungen werden unter Berücksichtigung der erfassten äußeren Abmessungen der Kabine 17, 27 definiert. In einem abschließenden dritten Schritt 43 werden die ausgewählten strukturellen Elemente 9a, 9b, 11a, 11b, 13a, 13b entsprechend der mit dem Verfahren ermittelten Anordnung in der Kabine 17, 27 angeordnet und die Kabine 17, 27 somit hergestellt.

Damit ist es auf vorteilhafte Weise möglich, eine Kabine 17, 27 mit einer Anordnung von strukturellen Elementen herzustellen, die unter Berücksichtigung einer Vielzahl von sich zeitlich ändernden Anforderungen automatisch ermittelt wurde.

## Patentansprüche

1. Verfahren zum automatisierten Auswählen einer Mehrzahl von strukturellen Elementen (9a, 9b, 11a, 11b, 13a, 13b) für einen begrenzten Raum und automatisierten Anordnen der Mehrzahl von strukturellen Elementen (9a, 9b, 11a, 11b, 13a, 13b) in dem begrenzten Raum,
wobei die strukturellen Elemente (9a, 9b, 11a, 11b, 13a, 13b) von einem auf einer Datenverarbeitungseinrichtung (3) ausgeführten Interpreter aus einer Vielzahl von Basiselementen, die in einer Elementdatenbank gespeichert sind, so ausgewählt und in dem begrenzten Raum (17) so angeordnet werden, dass in logische Regeln umgesetzte Anforderungen an den begrenzten Raum (17) erfüllt werden,
wobei die Anforderungen an den begrenzten Raum (17) Stellflächenanforderungen (15a), Elementanforderungen (15b) und Positionsanforderungen (15c) umfassen,
wobei jede Stellflächenanforderung (15a) eine Position einer Stellfläche (19a-19i) in dem begrenzten Raum (17) und eine Abmessung der Stellfläche (19a-19i) definiert, auf der ein oder mehrere strukturelle Elemente (9a, 9b, 11a, 11b, 13a, 13b) positioniert werden können,
wobei jede Elementanforderung (15b) zumindest ein strukturelles Element (9a, 9b, 11a, 11b, 13a, 13b) definiert, das in dem begrenzten Raum (17) angeordnet werden muss, und
wobei jede Positionsanforderung (15c) eine Position zumindest eines strukturellen Elements (9a, 9b, 11a, 11b, 13a, 13b) in dem begrenzten Raum (17) einschränkt, und
wobei für jedes Basiselement in der Elementdatenbank zumindest räumliche Abmessungen des Basiselements hinterlegt sind,
**dadurch gekennzeichnet,**
**dass** zumindest eine Positionsanforderung (15c) für eine Mehrzahl von Zeitpunkten verschiedene Werte annimmt, wobei jede Positionsanforderung (15c) für einen Zeitpunkt der Mehrzahl von Zeitpunkten einen Prozessschritt eines Prozesses darstellt, und
**dass** der Interpreter so ausgestaltet ist, dass für jeden Zeitpunkt der Mehrzahl von Zeitpunkten, an dem die zumindest eine Positionsanforderung (15c) einen der verschiedenen Werte annimmt, dieselben strukturellen Elemente (9a, 9b, 11a, 11b, 13a, 13b) von dem Interpreter aus der Vielzahl von Basiselementen aus der Elementdatenbank ausgewählt und in dem begrenzten Raum (17) angeordnet werden.

2. Verfahren nach Anspruch 1, wobei nachdem die automatisierte Auswahl und Anordnung der Mehrzahl von strukturellen Elementen (9a, 9b, 11a, 11b, 13a, 13b) für den begrenzten Raum (17) erfolgt ist, mittels der Datenverarbeitungseinrichtung (3) zumindest ein Maß bestimmt wird, das geeignet ist, um die erfolgte Auswahl und Anordnung der Mehrzahl von strukturellen Elementen (9a, 9b, 11a, 11b, 13a, 13b) in dem begrenzten Raum (17) zu bewerten.

3. Verfahren nach Anspruch 2, wobei das zumindest eine Maß einen Schwerpunkt des begrenzten Raums (17) umfasst.

4. Verfahren nach einem der vorhergehenden Ansprüche, wobei die Anforderungen an den begrenzten Raum (17) weiterhin Betriebsanforderungen (15d) umfassen, wobei jede Betriebsanforderung (15d) den Betrieb zumindest eines strukturellen Elements (9a, 9b, 11a, 11b, 13a, 13b) vorgibt,
wobei zumindest eine Betriebsanforderung (15d) für eine Mehrzahl von Zeitpunkten verschiedene Werte annimmt, wobei jede Betriebsanforderung (15d) für einen Zeitpunkt der Mehrzahl von Zeitpunkten einen Prozessschritt eines Prozesses darstellt, und
wobei der Interpreter so ausgestaltet ist, dass auch für jeden Zeitpunkt der Mehrzahl von Zeitpunkten, an dem die zumindest eine Betriebsanforderung (15d) einen Wert der verschiedene Werte annimmt und an dem die zumindest eine Positionsanforderung (15c) einen der verschiedenen Werte annimmt, dieselben strukturellen Elemente (9a, 9b, 11a, 11b, 13a, 13b) von dem Interpreter aus der Vielzahl von Basiselementen aus der Elementdatenbank ausgewählt und in dem begrenzten Raum (17) angeordnet werden.

5. Verfahren nach einem der vorhergehenden Ansprüche, wobei die Stellflächen (19a-i) innerhalb von äußeren Abmessungen des begrenzten Raums (17) liegen und durch eine oder mehrere Sperrflächen (21a-e) eingeschränkt werden, auf denen keine strukturellen Elemente (9a, 9b, 11a, 11b, 13a, 13b) positioniert werden dürfen.

6. Verfahren nach einem der vorhergehenden Ansprüche, wobei zumindest eine Stellflächenanforderung (15a) für eine Mehrzahl von Zeitpunkten verschiedene Abmessung einer Stellfläche (19a-i) definiert, auf der ein oder mehrere strukturelle Elemente (9a, 9b, 11a, 11b, 13a, 13b) positioniert werden können.

7. Verfahren nach einem der vorhergehenden Ansprüche, wobei die Anforderungen an den begrenzten Raum (17) Personalanforderungen (15e) und Tätigkeitsanforderungen (15f) umfassen,
wobei jede Personalanforderung (15e) die Anwesenheit zumindest einer Person in dem begrenzten Raum (17) definiert und Abmessungen vorgibt, die die zumindest eine Person in dem begrenzten Raum (17) einnimmt,
wobei jede Tätigkeitsanforderung (15f) die Tätigkeit zumindest einer in dem begrenzten Raum (17) anwesenden Person in Bezug auf zumindest ein strukturelles Element (9a, 9b, 11a, 11b, 13a, 13b) definiert,
wobei zumindest eine Tätigkeitsanforderung (15f) für eine Mehrzahl von Zeitpunkten verschiedene Werte annimmt, wobei jede Tätigkeitsanforderung (15f) für einen Zeitpunkt der Mehrzahl von Zeitpunkten einen Prozessschritt eines Prozesses darstellt, und
wobei der Interpreter so ausgestaltet ist, dass auch für jeden Zeitpunkt der Mehrzahl von Zeitpunkten, an dem die zumindest eine Tätigkeitsanforderung (15f) einen Wert der verschiedene Werte annimmt, dieselben strukturellen Elemente (9a, 9b, 11a, 11b, 13a, 13b) von dem Interpreter aus der Vielzahl von Basiselementen aus der Elementdatenbank ausgewählt und in dem begrenzten Raum (17) angeordnet werden.

8. Verfahren nach einem der vorhergehenden Ansprüche, wobei das Definieren der Stellflächenanforderungen (15a) ein Ermitteln von Abmessungen des begrenzten Raumes (17) umfasst.

9. Verfahren nach einem der vorhergehenden Ansprüche, wobei der begrenzte Raum (17) eine Fahrzeugkabine, vorzugsweise eine Kabine (27) eines Passagierflugzeugs ist.

10. Verfahren nach Anspruch 2 und 9, wobei die Elementanforderungen (15b) zumindest eine erste Anzahl von Passagiersitzplätzen in der Fahrzeugkabine sowie eine zweite Anzahl von Kabinenpersonalsitzplätzen umfasst, und
wobei das Maß ein Anteil der Passagiersitzplätze ist, die in einem Sichtfeld von Kabinenpersonalsitzplätzen liegen.

11. Verfahren nach Anspruch 9 oder 10, wobei die Elementanforderungen (15b) zumindest eine erste Anzahl von Passagiersitzplätzen in der Fahrzeugkabine und
die Anforderungen an den begrenzten Raum (17) Passagieranforderungen umfassen, wobei jede Passagieranforderung die Anwesenheit zumindest eines Passagiers in dem begrenzten Raum (17) definiert, Abmessungen vorgibt, die der zumindest eine Passagier in dem begrenzten Raum (17) einnimmt, und Beschränkungen definiert, auf welchen Passagiersitzplätzen in dem begrenzten Raum (17) der zumindest eine Passagier angeordnet werden darf.

12. Verfahren zur Evaluierung eines Prozesses für eine Mehrzahl von verschiedenen Konfigurationen eines begrenzten Raumes (17), bei dem für jede Konfiguration der Mehrzahl von verschiedenen Konfiguration ein Satz von zumindest teilweise unterschiedlichen Anforderungen für den gleichen begrenzten Raum (17) definiert ist, wobei jeder Satz von Anforderungen eine Mehrzahl von Anforderungen umfasst, die dieselben Prozessschritte zumindest eines zu evaluierenden Prozesses darstellen,
wobei für jede Konfiguration des begrenzten Raumes (17) eine Anordnung von strukturellen Elementen (9a, 9b, 11a, 11b, 13a, 13b) in dem begrenzten Raum (17) bestimmt wird, indem das Verfahren zum automatisierten Auswählen einer Mehrzahl von strukturellen Elementen (9a, 9b, 11a, 11b, 13a, 13b) für einen begrenzten Raum (17) und automatisierten Anordnen der Mehrzahl von strukturellen Elementen (9a, 9b, 11a, 11b, 13a, 13b) in dem begrenzten Raum (17) nach einem der Ansprüche 2 bis 10, sofern abhängig von Anspruch 2, unter Verwendung des Satzes von Anforderungen, der für die jeweilige Konfiguration definiert wurde, durchgeführt wird, und
wobei zur Evaluierung des Prozesses für jede Konfigurationen des begrenzten Raumes (17) das zumindest eine Maß bestimmt wird, wobei für alle Konfigurationen des begrenzten Raumes (17) zumindest ein einheitliches Maß bestimmt wird.

13. Verfahren zur Herstellung einer Fahrzeugkabine, bei dem eine Mehrzahl von strukturellen Elementen (9a, 9b, 11a, 11b, 13a, 13b) in die Fahrzeugkabine eingebaut wird, wobei das Verfahren die folgenden Schritte umfasst:
Erfassen von äußeren Abmessungen der Fahrzeugkabine, innerhalb derer die Mehrzahl von strukturellen Elementen (9a, 9b, 11a, 11b, 13a, 13b) angeordnet werden muss,
Durchführung eines Verfahrens nach Anspruch 9 oder 10 zur Ermittlung einer automatisierten Auswahl der Mehrzahl von strukturellen Elementen (9a, 9b, 11a, 11b, 13a, 13b) zum Einbau in die Fahrzeugkabine und zur automatisierten Bestimmung der Anordnung der Mehrzahl von strukturellen Elementen (9a, 9b, 11a, 11b, 13a, 13b) zum Einbau in der Fahrzeugkabine, wobei die Stellflächenanforderungen (15a) unter Berücksichtigung der erfassten äußeren Abmessungen der Fahrzeugkabine definiert werden, und
Einbau der Mehrzahl von mittels des Verfahrens nach Anspruch 9 oder 10 ausgewählten strukturellen Elemente (9a, 9b, 11a, 11b, 13a, 13b) entsprechend der mittels des Verfahrens nach Anspruch 9 oder 10 ermittelten Anordnung in der Fahrzeugkabine.

14. System zum automatisierten Auswählen einer Mehrzahl von strukturellen Elementen (9a, 9b, 11a, 11b, 13a, 13b) für einen begrenzten Raum (17) und automatisierten Anordnen der Mehrzahl von strukturellen Elementen (9a, 9b, 11a, 11b, 13a, 13b) in dem begrenzten Raum (17), wobei das System (1) eine Datenverarbeitungseinrichtung (3) und einen Datenspeicher (5) umfasst,
wobei das System dazu eingerichtet ist, ein Verfahren nach einem der Ansprüche 1 bis 10 auszuführen, wobei die Elementdatenbank in dem Datenspeicher (5) gespeichert ist.

## Claims

1. Method for automatically selecting a plurality of structural elements (9a, 9b, 11a, 11b, 13a, 13b) for a limited space and automatically arranging the plurality of structural elements (9a, 9b, 11a, 11b, 13a, 13b) in the limited space,
wherein the structural elements (9a, 9b, 11a, 11b, 13a, 13b) are selected from a multiplicity of basic elements stored in an element database by an interpreter executed on a data processing device (3) and are arranged in the limited space (17) in such a way that requirements for the limited space (17) that have been converted into logical rules are met,
wherein the requirements for the limited space (17) comprise footprint requirements (15a), element requirements (15b) and position requirements (15c), wherein each footprint requirement (15a) defines a position of a footprint (19a-19i) in the limited space (17) and a dimension of the footprint (19a-19i) on which one or more structural elements (9a, 9b, 11a, 11b, 13a, 13b) can be positioned,
wherein each element requirement (15b) defines at least one structural element (9a, 9b, 11a, 11b, 13a, 13b) which must be arranged in the limited space (17), and wherein each position requirement (15c) restricts a position of at least one structural element (9a, 9b, 11a, 11b, 13a, 13b) in the limited space (17), and wherein at least spatial dimensions of the basic element are stored for each basic element in the element database,
**characterized**
**in that** at least one position requirement (15c) assumes different values for a plurality of times, wherein each position requirement (15c) for a time of the plurality of times represents a process step of a process, and
**in that** the interpreter is configured such that, for each time of the plurality of times at which the at least one position requirement (15c) assumes one of the different values, the same structural elements (9a, 9b, 11a, 11b, 13a, 13b) are selected from the multiplicity of basic elements from the element database by the interpreter and are arranged in the limited space (17).

2. Method according to Claim 1, wherein, after the plurality of structural elements (9a, 9b, 11a, 11b, 13a, 13b) have been automatically selected and arranged for the limited space (17), at least one measure is determined by means of the data processing device (3) and is suitable for assessing the selection and arrangement of the plurality of structural elements (9a, 9b, 11a, 11b, 13a, 13b) in the limited space (17).

3. Method according to Claim 2, wherein the at least one measure comprises a centroid of the limited space (17).

4. Method according to one of the preceding claims, wherein the requirements for the limited space (17) further comprise operating requirements (15d), wherein each operating requirement (15d) specifies the operation of at least one structural element (9a, 9b, 11a, 11b, 13a, 13b),
wherein at least one operating requirement (15d) assumes different values for a plurality of times, wherein each operating requirement (15d) for a time of the plurality of times represents a process step of a process, and
wherein the interpreter is configured such that, for each time of the plurality of times at which the at least one operating requirement (15d) assumes a value of the different values and at which the at least one position requirement (15c) assumes one of the different values, the same structural elements (9a, 9b, 11a, 11b, 13a, 13b) are also selected from the multiplicity of basic elements from the element database by the interpreter and are arranged in the limited space (17).

5. Method according to one of the preceding claims, wherein the footprints (19a-i) lie within outer dimensions of the limited space (17) and are restricted by one or more blocked areas (21a-e), on which no structural elements (9a, 9b, 11a, 11b, 13a, 13b) can be positioned.

6. Method according to one of the preceding claims, wherein at least one footprint requirement (15a) for a plurality of times defines different dimensions of a footprint (19a-i), on which one or more structural elements (9a, 9b, 11a, 11b, 13a, 13b) can be positioned.

7. Method according to one of the preceding claims, wherein the requirements for the limited space (17) comprise personnel requirements (15e) and activity requirements (15f),
wherein each personnel requirement (15e) defines the presence of at least one person in the limited space (17) and specifies dimensions that are occupied by the at least one person in the limited space (17),
wherein each activity requirement (15f) defines the activity of at least one person present in the limited space (17) with respect to at least one structural element (9a, 9b, 11a, 11b, 13a, 13b),
wherein at least one activity requirement (15f) assumes different values for a plurality of times, wherein each activity requirement (15f) for a time of the plurality of times represents a process step of a process, and
wherein the interpreter is configured such that, for each time of the plurality of times at which the at least one activity requirement (15f) assumes a value of the different values, the same structural elements (9a, 9b, 11a, 11b, 13a, 13b) are also selected from the multiplicity of basic elements from the element database by the interpreter and are arranged in the limited space (17).

8. Method according to one of the preceding claims, wherein defining the footprint requirements (15a) comprises determining dimensions of the limited space (17).

9. Method according to one of the preceding claims, wherein the limited space (17) is a vehicle cabin, preferably a cabin (27) of a passenger aircraft.

10. Method according to Claims 2 and 9, wherein the element requirements (15b) comprise at least a first number of passenger seats in the vehicle cabin and a second number of cabin personnel seats, and
wherein the measure is a proportion of the passenger seats within a field of view of cabin personnel seats.

11. Method according to Claim 9 or 10, wherein the element requirements (15b) comprise at least a first number of passenger seats in the vehicle cabin and
the requirements for the limited space (17) comprise passenger requirements, wherein each passenger requirement defines the presence of at least one passenger in the limited space (17), specifies dimensions that are occupied by the at least one passenger in the limited space (17), and defines restrictions as regards the passenger seats in the limited space (17) on which the at least one passenger may be arranged.

12. Method for evaluating a process for a plurality of different configurations of a limited space (17), in which, for each configuration of the plurality of different configurations, a set of at least partially different requirements is defined for the same limited space (17), wherein each set of requirements comprises a plurality of requirements representing the same process steps of at least one process to be evaluated,
wherein, for each configuration of the limited space (17), an arrangement of structural elements (9a, 9b, 11a, 11b, 13a, 13b) in the limited space (17) is determined by carrying out the method for automatically selecting a plurality of structural elements (9a, 9b, 11a, 11b, 13a, 13b) for a limited space (17) and automatically arranging the plurality of structural elements (9a, 9b, 11a, 11b, 13a, 13b) in the limited space (17) according to one of Claims 2 to 10, if dependent on Claim 2, using the set of requirements defined for the respective configuration, and
wherein, in order to evaluate the process for each configuration of the limited space (17), the at least one measure is determined, wherein at least one consistent measure is determined for all configurations of the limited space (17).

13. Method for producing a vehicle cabin, in which a plurality of structural elements (9a, 9b, 11a, 11b, 13a, 13b) are installed in the vehicle cabin, wherein the method comprises the following steps:
detecting outer dimensions of the vehicle cabin, within which the plurality of structural elements (9a, 9b, 11a, 11b, 13a, 13b) must be arranged,
carrying out a method according to Claim 9 or 10 for determining an automated selection of the plurality of structural elements (9a, 9b, 11a, 11b, 13a, 13b) for installation in the vehicle cabin and for automatically determining the arrangement of the plurality of structural elements (9a, 9b, 11a, 11b, 13a, 13b) for installation in the vehicle cabin, wherein the footprint requirements (15a) are defined taking into account the detected outer dimensions of the vehicle cabin, and
installing the plurality of structural elements (9a, 9b, 11a, 11b, 13a, 13b) selected by means of the method according to Claim 9 or 10 according to the arrangement in the vehicle cabin determined by means of the method according to Claim 9 or 10.

14. System for automatically selecting a plurality of structural elements (9a, 9b, 11a, 11b, 13a, 13b) for a limited space (17) and automatically arranging the plurality of structural elements (9a, 9b, 11a, 11b, 13a, 13b) in the limited space (17), wherein the system (1) comprises a data processing device (3) and a data memory (5), wherein the system is configured to carry out a method according to one of Claims 1 to 10, wherein the element database is stored in the data memory (5).

## Revendications

1. Procédé de sélection automatisée d'une pluralité d'éléments structurels (9a, 9b, 11a, 11b, 13a, 13b) pour un espace limité et d'agencement automatisé de la pluralité d'éléments structurels (9a, 9b, 11a, 11b, 13a, 13b) dans l'espace limité,
les éléments structurels (9a, 9b, 11a, 11b, 13a, 13b) étant sélectionnés par un interpréteur exécuté sur un dispositif de traitement de données (3) parmi une pluralité d'éléments de base stockés dans une base de données d'éléments et étant agencés dans l'espace limité (17) de telle sorte que des exigences converties en règles logiques concernant l'espace limité (17) soient satisfaites,
les exigences concernant l'espace limité (17) comprenant des exigences d'emplacement (15a), des exigences d'élément (15b) et des exigences de position (15c),
chaque exigence d'emplacement (15a) définissant une position d'emplacement (19a-19i) dans l'espace limité (17) et une dimension de l'emplacement (19a-19i) sur lequel un ou plusieurs éléments structurels (93, 9b, 11a, 11b, 13a, 13b) peuvent être positionnés,
chaque exigence d'élément (15b) définissant au moins un élément structurel (9a, 9b, 11a, 11b, 13a, 13b) qui doit être agencé dans l'espace limité (17), et
chaque exigence de position (15c) restreignant une position d'au moins un élément structurel (9a, 9b, 11a, 11b, 13a, 13b) dans l'espace limité (17), et
pour chaque élément de base, au moins des dimensions spatiales de l'élément de base étant stockées dans la base de données d'éléments,
**caractérisé**
**en ce qu'**au moins une exigence de position (15c) prend des valeurs différentes pour une pluralité d'instants, chaque exigence de position (15c) pour un instant de la pluralité d'instants représentant une étape de processus d'un processus, et
**en ce que** l'interpréteur est conçu de telle sorte que, pour chaque instant de la pluralité d'instants auxquels l'au moins une exigence de position (15c) prend l'une des différentes valeurs, les mêmes éléments structurels (9a, 9b, 11a, 11b, 13a, 13b) sont sélectionnés par l'interpréteur parmi la pluralité d'éléments de base provenant de la base de données d'éléments et sont agencés dans l'espace limité (17).

2. Procédé selon la revendication 1, dans lequel, après que la sélection et l'agencement automatisés de la pluralité d'éléments structurels (9a, 9b, 11a, 11b, 13a, 13b) pour l'espace limité (17) ont été effectués, au moins une mesure appropriée pour évaluer la sélection et l'agencement effectués de la pluralité d'éléments structurels (9a, 9b, 11a, 11b, 13a, 13b) dans l'espace limité (17) est déterminée au moyen du dispositif de traitement de données (3).

3. Procédé selon la revendication 2, dans lequel l'au moins une mesure comprend un centre de gravité de l'espace limité (17).

4. Procédé selon l'une quelconque des revendications précédentes, dans lequel les exigences concernant l'espace limité (17) comprennent en outre des exigences de fonctionnement (15d), chaque exigence de fonctionnement (15d) spécifiant le fonctionnement d'au moins un élément structurel (9a, 9b, 11a, 11b, 13a, 13b), dans lequel au moins une exigence de fonctionnement (15d) prend des valeurs différentes pour une pluralité d'instants, chaque exigence de fonctionnement (15d) pour un instant de la pluralité d'instants représentant une étape de processus d'un processus, et
dans lequel l'interpréteur est conçu de telle sorte que, même pour chaque instant de la pluralité d'instants où l'au moins une exigence de fonctionnement (15d) prend l'une des différentes valeurs et où l'au moins une exigence de position (15c) prend l'une des différentes valeurs, les mêmes éléments structurels (9a, 9b, 11a, 11b, 13a, 13b) sont sélectionnés par l'interpréteur parmi la pluralité d'éléments de base provenant de la base de données d'éléments et sont agencés dans l'espace limité (17).

5. Procédé selon l'une quelconque des revendications précédentes, dans lequel les emplacements (19a-i) sont situés à l'intérieur de dimensions extérieures de l'espace limité (17) et sont limités par une ou plusieurs surfaces de blocage (21a-e) sur lesquelles aucun élément structurel (9a, 9b, 11a, 11b, 13a, 13b) ne peut être positionné.

6. Procédé selon l'une quelconque des revendications précédentes, dans lequel au moins une exigence d'emplacement (15a) définit, pour une pluralité d'instants, des dimensions différentes d'un emplacement (19a-i) sur lequel un ou plusieurs éléments structurels (9a, 9b, 11a, 11b, 13a, 13b) peuvent être positionnés.

7. Procédé selon l'une quelconque des revendications précédentes, dans lequel les exigences concernant l'espace limité (17) comprennent des exigences de personnel (15e) et des exigences d'activité (15f),
dans lequel chaque exigence de personnel (15e) définit la présence d'au moins une personne dans l'espace limité (17) et spécifie des dimensions que l'au moins une personne occupe dans l'espace limité (17),
dans lequel chaque exigence d'activité (15f) définit l'activité d'au moins une personne présente dans l'espace limité (17) par rapport à au moins un élément structurel (9a, 9b, 11a, 11b, 13a, 13b),
dans lequel au moins une exigence d'activité (15f) prend des valeurs différentes pour une pluralité d'instants, chaque exigence d'activité (15f) pour un instant de la pluralité d'instants représentant une étape de processus d'un processus, et
dans lequel l'interpréteur est conçu de telle sorte que, même pour chaque instant de la pluralité d'instants auxquels l'au moins une exigence d'activité (15f) prend une valeur parmi les différentes valeurs, les mêmes éléments structurels (9a, 9b, 11a, 11b, 13a, 13b) sont sélectionnés par l'interpréteur parmi la pluralité d'éléments de base provenant de la base de données d'éléments et sont agencés dans l'espace limité (17).

8. Procédé selon l'une quelconque des revendications précédentes, dans lequel la définition des exigences d'emplacement (15a) comprend une détermination des dimensions de l'espace limité (17).

9. Procédé selon l'une quelconque des revendications précédentes, dans lequel l'espace limité (17) est une cabine de véhicule, de préférence une cabine (27) d'un aéronef de passagers.

10. Procédé selon les revendications 2 et 9, dans lequel les exigences d'élément (15b) comprennent au moins un premier nombre de sièges de passager dans la cabine de véhicule et un deuxième nombre de sièges de personnel de cabine, et dans lequel la mesure est une proportion de sièges de passager situés dans un champ de vision des sièges de personnel de cabine.

11. Procédé selon la revendication 9 ou 10, dans lequel les exigences d'élément (15b) comprennent au moins un premier nombre de sièges de passager dans la cabine de véhicule et
les exigences concernant l'espace limité (17) comprennent des exigences de passager, chaque exigence de passager définissant la présence d'au moins un passager dans l'espace limité (17), spécifiant des dimensions que l'au moins un passager occupe dans l'espace limité (17), et définissant des restrictions quant aux sièges de passager dans l'espace limité (17) sur lesquels l'au moins un passager peut être agencé.

12. Procédé d'évaluation d'un processus pour une pluralité de configurations différentes d'un espace limité (17), dans lequel, pour chaque configuration de la pluralité de configurations différentes, un ensemble d'exigences au moins partiellement différentes est défini pour le même espace limité (17), chaque ensemble d'exigences comprenant une pluralité d'exigences qui représentent les mêmes étapes de processus d'au moins un processus à évaluer,
dans lequel, pour chaque configuration de l'espace limité (17), un agencement d'éléments structurels (9a, 9b, 11a, 11b, 13a, 13b) dans l'espace limité (17) est déterminé en exécutant le procédé de sélection automatisée d'une pluralité d'éléments structurels (9a, 9b, 11a, 11b, 13a, 13b) pour un espace limité (17) et d'agencement automatisé de la pluralité d'éléments structurels (9a, 9b, 11a, 11b, 13a, 13b) dans l'espace limité (17) selon l'une quelconque des revendications 2 à 10, dans la mesure où elles dépendent de la revendication 2, en utilisant l'ensemble d'exigences défini pour la configuration respective, et
dans lequel, pour évaluer le processus, l'au moins une mesure est déterminée pour chaque configuration de l'espace limité (17), au moins une mesure uniforme étant déterminée pour toutes les configurations de l'espace limité (17).

13. Procédé de fabrication d'une cabine de véhicule, dans lequel une pluralité d'éléments structurels (9a, 9b, 11a, 11b, 13a, 13b) sont installés dans la cabine de véhicule, le procédé comprenant les étapes suivantes :
la détection de dimensions extérieures de la cabine de véhicule à l'intérieur desquelles la pluralité d'éléments structurels (9a, 9b, 11a, 11b, 13a, 13b) doit être agencés,
l'exécution d'un procédé selon la revendication 9 ou 10 pour déterminer une sélection automatisée de la pluralité d'éléments structurels (9a, 9b, 11a, 11b, 13a, 13b) destinés à être installés dans la cabine de véhicule et pour déterminer de manière automatisée l'agencement de la pluralité d'éléments structurels (9a, 9b, 11a, 11b, 13a, 13b) destinés à être installés dans la cabine de véhicule, dans lequel les exigences d'emplacement (15a) sont définies en tenant compte des dimensions extérieures détectées de la cabine de véhicule, et
l'installation de la pluralité d'éléments structurels (9a, 9b, 11a, 11b, 13a, 13b) sélectionnés par le procédé selon la revendication 9 ou 10, selon l'agencement déterminé par le procédé selon la revendication 9 ou 10, dans la cabine de véhicule.

14. Système pour sélectionner automatiquement une pluralité d'éléments structurels (9a, 9b, 11a, 11b, 13a, 13b) pour un espace limité (17) et pour agencer automatiquement la pluralité d'éléments structurels (9a, 9b, 11a, 11b, 13a, 13b) dans l'espace limité (17), le système (1) comprenant un dispositif de traitement de données (3) et une mémoire de données (5),
dans lequel le système est adapté pour exécuter un procédé selon l'une quelconque des revendications 1 à 10, dans lequel la base de données d'éléments est stockée dans la mémoire de données (5).
